# FASCICULE DE BREVET EUROPEEN

(11) **EP 1 966 825 B1**
(45) Date de publication et mention de la délivrance du brevet: **21.10.2009**
(21) Numéro de dépôt: 06841479.6
(22) Date de dépôt: 19.12.2006
(51) Int. Cl.: H01L 23/48, H01L 21/98, H01L 25/065

(54) **PROCEDE DE FABRICATION COLLECTIVE DE MODULES ELECTRONIQUES 3D**
VERFAHREN ZUR GEMEINSAMEN HERSTELLUNG VON ELEKTRONISCHEN 3D-MODULEN
PROCESS FOR THE COLLECTIVE FABRICATION OF 3D ELECTRONIC MODULES

(30) Priorité: 23.12.2005 FR 0513217
(43) Date de publication de la demande: 10.09.2008
(73) Titulaire: 3D Plus, 78532 Buc Cedex (FR)
(72) Inventeur: VAL, Christian, F-78470 St Remy Les Chevreuse (FR)
(74) Mandataire: Henriot, Marie-Pierre
(86) Numéro de dépôt international: PCT/EP2006/069948
(87) Numéro de publication internationale: WO 2007/071696

(56) Documents cités:
- WO-A-03/073505
- DE-A1- 19 842 481
- US-A1- 2003 173 673
- US-A1- 2004 221 451
- US-B1- 6 380 629
- US-B1- 6 391 685

## Description

Le domaine de l'invention est celui de la fabrication de modules électroniques 3D.

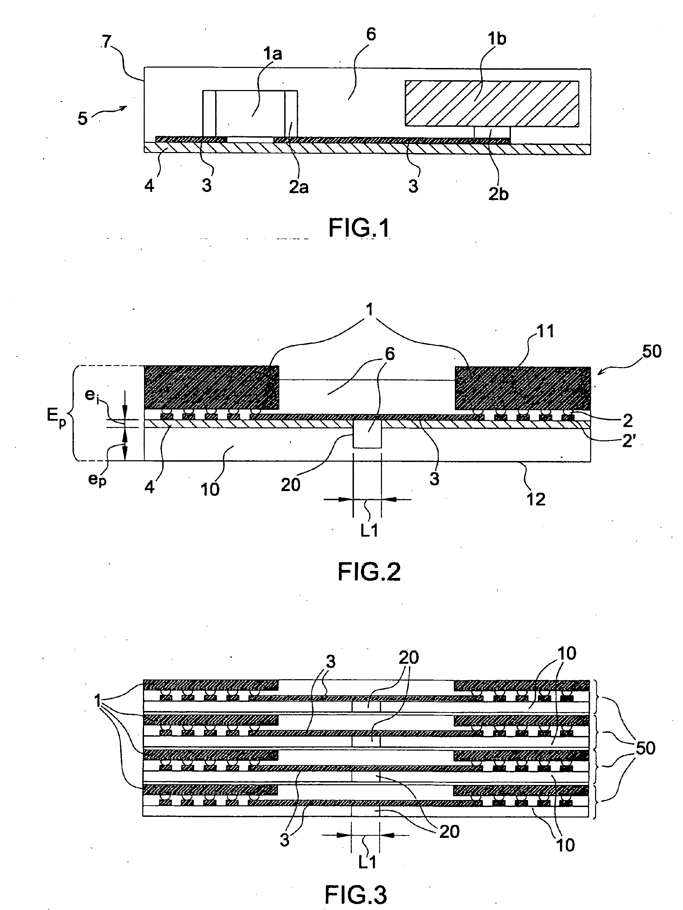

Un module électronique 3 D comprend un empilement de tranches électroniques dont l'interconnexion s'effectue en trois dimensions en utilisant les faces de l'empilement pour réaliser les connexions entre les tranches. Une tranche 5 dont un exemple est représenté figure 1, comprend généralement un ou plusieurs composants actifs 1 b ou passifs 1 a qui ont des éléments de connexion électrique 2b ou 2a, les composants étant enrobés dans une résine 6 électriquement isolante. Les éléments de connexion 2a ou 2b des composants sont reliés à des plots de connexion portés par un substrat électriquement isolant 4. Une ou plusieurs pistes 3 électriquement conductrices portées par le substrat isolant 4 relient ces composants entre eux ou les relient à des éléments de connexion électrique des tranches entre elles. Les tranches sont reliées électriquement entre elles par des conducteurs situés sur les faces latérales de l'empilement, c'est-à-dire sur les bords 7 des tranches.

II existe plusieurs méthodes pour connecter les plots du composant à ceux du substrat.

Une méthode consiste à connecter directement les plots du composant sur ceux du substrat isolant en envoyant des ultra-sons. L'énergie envoyée est proportionnelle au nombre de plots à connecter. Pour des composants comportant un grand nombre de plots, l'énergie nécessaire pour la connexion provoque parfois une cassure du composant. Une solution pour réduire cette énergie consiste à chauffer le substrat qui alors s'amollit et absorbe une partie de l'énergie ultrasonore envoyée ce qui rend la connexion très difficile. En outre, lors de l'enrobage des composants par polymérisation réalisée à environ 150°, le substrat tend à se courber car le coefficient de dilatation des composants est différent de celui du substrat, typiquement 4 fois inférieur.

Le but de l'invention est de pallier ces inconvénients.

Le principe de l'invention est de conserver une bonne continuité de matériau entre le composant et le substrat pour éviter les différences de dilatation pendant l'étape de connexion et/ou de polymérisation, tout en isolant électriquement les composants entre eux.

Plus précisément l'invention a pour objet un procédé de fabrication de n modules électroniques, n étant un entier supérieur à 1, un module comportant un empilement de K tranches électroniques, une tranche i, i variant de 1 à K comprenant sur un substrat isolant au moins un composant électronique, les K tranches étant reliées électriquement entre elles par des conducteurs situés sur les faces latérales de l'empilement, caractérisé en ce que la fabrication est collective et comprend :
une première étape consistant pour chaque tranche i, en :
   A1) une étape de fabrication d'un lot de n tranches i sur une même plaque mince plane d'épaisseur eₚ comprenant du silicium, recouverte sur une face d'une couche mince électriquement isolante d'épaisseur eᵢ, formant le substrat, avec sur cette face des rainures de largeur L1 et de profondeur supérieure à eᵢ et inférieure eₚ+eᵢ, ces rainures délimitant au moins n motifs géométriques, chaque motif étant muni d'au moins un composant électronique connecté à des plots de connexion électrique disposés sur ladite face, les plots étant reliés à des éléments de connexion électrique s'étendant au moins jusqu'à une rainure, une zone d'ouverture d'un trou étant prévue à l'intersection des rainures et des éléments de connexion, la dimension transverse de cette zone étant inférieure à L1, les composants étant enrobés d'une résine isolante qui remplit aussi les rainures,
   B1) une étape d'amincissement par surfaçage de l'autre face de la plaque de manière à faire apparaître la résine des rainures, une deuxième étape consistant à :
   A2) empiler et assembler les K lots obtenus à l'issue de la première étape, de manière à superposer les zones d'ouverture, sensiblement les unes sur les autres,
   B2) percer des trous dans la résine perpendiculairement aux faces des plaques sur toute l'épaisseur de l'empilement à l'aplomb des zones d'ouverture, la dimension transverse des trous étant inférieure à L1, de manière à ce que le silicium soit isolé de la paroi du trou par de la résine,
   C2) métalliser la paroi des trous,
   D2) découper l'empilement selon les rainures en vue d'obtenir les n modules électroniques.

Avantageusement, il comprend en outre préalablement à la deuxième l'étape, une étape supplémentaire d'amincissement de la plaque par surfaçage de l'autre face de la plaque.

Selon une caractéristique de l'invention, il comprend une étape consistant à déposer une couche électriquement isolante sur une face de l'empilement parallèle aux plaques, cette couche comprenant au niveau de chaque motif, des éléments d'interconnexion électrique du module qui ménagent des zones d'ouverture centrées sur les zones d'ouverture des tranches, et qui s'étendent jusqu'à ces zones.

Selon une autre caractéristique de l'invention, la deuxième étape comprend en outre une étape suivant l'étape de métallisation des parois des trous, consistant à reboucher les trous avec de la résine en vue de faciliter la découpe ultérieure de l'empilement.

Le composant électronique peut être un composant actif tel qu'une puce nue ou un composant passif ou un MEMS (acronyme de l'expression anglo-saxonne Micro Electro Mechanical System).

La plaque est telle qu'au moins un composant passif est situé dans la plaque ou sur la plaque.

Selon une caractéristique de l'invention, la couche mince isolante est en résine isolante.

Selon une autre caractéristique de l'invention, les éléments de connexion électriques enjambent les rainures.

Eventuellement, des éléments de connexion électrique relient deux plots situés de part et d'autre d'une rainure.

De préférence, il comprend en outre préalablement au découpage de l'étape D2, une étape consistant à tester électriquement l'empilement obtenu.

Selon un mode de réalisation de l'invention, les éléments de connexion électriques sont des ponts gravés. Ils sont gravés après avoir rempli les rainures de résine et avant d'enrober les composants de résine.

Selon un autre mode de réalisation de l'invention, les éléments de connexion électriques sont des fils câblés éventuellement sectionnés le long des rainures.

Les trous sont percés par gravure sèche ou liquide.

D'autres caractéristiques et avantages de l'invention apparaîtront à la lecture de la description détaillée qui suit, faite à titre d'exemple non limitatif et en référence aux dessins annexés dans lesquels :
la figure 1 déjà décrite représente schématiquement une tranche électronique d'un module 3D, selon l'état de la technique,
la figure 2 représente schématiquement une tranche électronique obtenue selon l'invention avant amincissement,
la figure 3 représente schématiquement un empilement de 4 tranches obtenu selon l'invention,
les figures 4a à 4c représentent schématiquement les étapes de rainurage d'une plaque de silicium selon l'invention, et de remplissage des rainures, la figure 4b' étant un zoom de la figure 4b,
la figure 5a et son zoom figure 5a' représentent schématiquement l'étape de distribution d'éléments de connexion électrique sur la plaque obtenue à l'issue de l'étape de la figure 4c,
la figure 5b et son zoom figure 5b' représentent schématiquement l'étape de report de composants électroniques,
la figure 6 représente schématiquement l'étape d'enrobage des composants;
la figure 7 représente schématiquement l'étape d'amincissement double face,
la figure 8 représente schématiquement l'étape d'empilement et d'assemblage,
la figure 9a et son zoom figure 9a' représentent schématiquement l'étape de dépôt sur une face de l'empilement, d'une couche isolante et de distribution d'éléments d'interconnexion, de percement de trous,
la figure 9b représente schématiquement le dépôt d'une couche métallique dans les trous et de rebouchage des trous métallisés par de la résine,
la figure 10 et son zoom figure 10' représentent schématiquement un module 3D obtenu après découpage.

D'une figure à l'autre, les mêmes éléments sont repérés par les mêmes références.

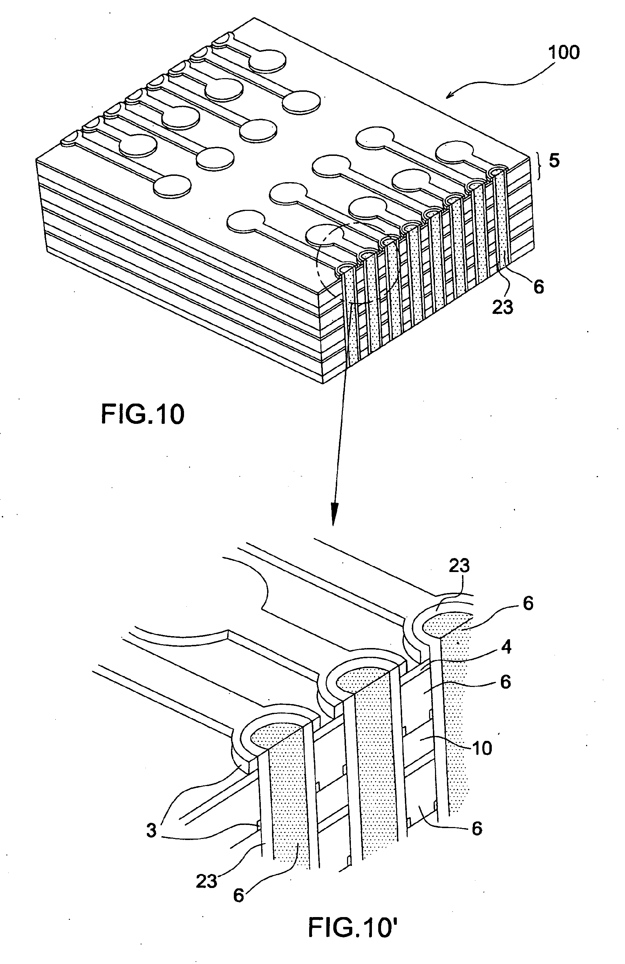

Un module électronique 3D 100 dont un exemple est représenté figure 10, comporte un empilement de K tranches électroniques 5 ; une tranche i, i variant de 1 à K comprend sur un substrat isolant 4 au moins un composant électronique 1. Les K tranches sont reliées électriquement entre elles par des conducteurs 23 situés sur les faces latérales de l'empilement. K est par exemple égal à 4 mais varie typiquement entre 2 et 100.

L'invention concerne la fabrication de n modules ( n compris entre 2 et 500), cette fabrication étant collective.

Elle comprend une étape de fabrication d'un lot de n tranches i sur une même plaque, cette étape étant répétée K fois, puis une étape d'empilement des K plaques, de formation de trous métallisés dans l'épaisseur de l'empilement et destinés à la connexion des tranches entre elles, puis de découpe de l'empilement pour obtenir les n modules 3D.

Un lot 50 de n tranches i dont un exemple est représenté figure 2, est obtenu sur une même plaque 10 mince plane d'épaisseur eₚ comprenant du silicium. L'épaisseur de la plaque 10 est de l'ordre de quelques centaines de µm. Des composants passifs sont éventuellement déjà dans la plaque ou sur la plaque. Cette plaque permet de maintenir une continuité pendant la fabrication collective. Il s'agit par exemple d'une plaque circulaire d'un diamètre d'environ 25 cm.

Elle est recouverte sur une face 11 d'une couche mince électriquement isolante formant le substrat isolant 4 d'épaisseur eᵢ, de quelques µm. Cette face présente des rainures 20 de largeur L1 ( L1 est typiquement compris entre 100 µm et 200 µm) et de profondeur supérieure à eᵢ et inférieure eₚ+eᵢ ; ces rainures délimitent au moins n motifs géométriques 25, chaque motif étant muni d'au moins un composant électronique 1 en silicium connecté à des plots de connexion électrique 2' disposés sur ladite face. Un composant a typiquement une épaisseur comprise entre 50µm et 500 µm. Les plots 2' sont reliés à des éléments d'interconnexion électrique du composant tels que des pistes 3 qui s'étendent au moins jusqu'à une rainure 20, une zone d'ouverture 21 d'un trou étant prévue à l'intersection des rainures 20 et des éléments d'interconnexion 3. Les dimensions de ces zones d'ouverture diffèrent éventuellement d'une plaque à l'autre. On a par exemple une zone circulaire. Les composants 1 sont enrobés d'une résine isolante 6 qui remplit aussi les rainures 20. La plaque 10 est amincie par surfaçage de l'autre face 12 de manière à faire apparaître la résine des rainures. L'épaisseur eₚ est alors comprise entre quelques µm et 100 µm. Ces rainures 20 permettent ainsi d'isoler électriquement chaque module 3D 100. Le surfaçage est réalisé par abrasion mécanique ou chimique.

De préférence, le procédé comprend en outre une étape consistant à amincir la plaque munie de ses composants par un surfaçage du côté de la face 11 de la plaque, c'est-à-dire par surfaçage des composants et éventuellement de la résine. L'épaisseur Eₚ de la plaque et de ses composants est alors diminuée par un surfaçage réalisé sur les deux faces de la plaque munie de ses composants. On obtient par exemple : 50 µm<Eₚ<200 µm.

Une deuxième étape consiste à empiler et assembler les K lots obtenus à l'issue de la première étape, comme illustré figure 3 de manière à superposer les zones d'ouverture 21 de chaque lot 50, sensiblement les unes sur les autres. Ces zones 21 sont de préférence de mêmes dimensions, mais pas nécessairement. Des trous 22 sont alors percés perpendiculairement aux faces des plaques sur toute l'épaisseur de l'empilement à l'aplomb des zones d'ouverture 21 ; la dimension transverse des trous est inférieure à L1, de manière à ce que le silicium de chaque tranche 10 soit isolé de la paroi du trou par de la résine. Lorsque le trou est circulaire son diamètre est par exemple de 50 µm à 100 µm. La paroi des trous 21 est alors métallisée avec une couche métallique 23. L'empilement est découpé selon les rainures 20 en vue d'obtenir les n modules électroniques 100. Cette découpe est par exemple effectuée par sciage.

La couche mince isolante 4 est éventuellement en résine isolante.

De préférence, il est prévu une étape préalable au découpage de l'empilement, qui consiste à tester électriquement l'empilement obtenu. Cela permet de réaliser ce test de manière collective plutôt qu'individuellement sur chaque module obtenu.

Avantageusement, préalablement à la découpe de l'empilement, il comprend une étape consistant à déposer une peau de tambour sur l'une des 2 faces de l'empilement.

On va à présent décrire deux exemples de modes de réalisation.

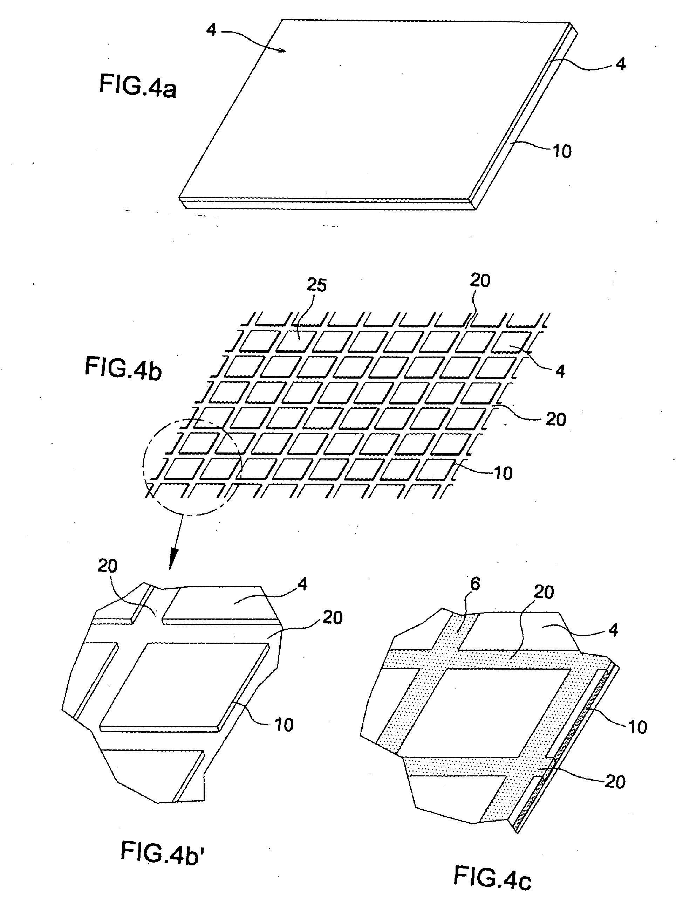

Selon un premier mode de réalisation, décrit en relation avec les figures 4 à 10, une couche mince 4 d'un matériau isolant est déposée sur une face 11 de la plaque, puis des rainures 20 sont découpées dans la plaque sur cette même face selon par exemple un même motif 25 rectangulaire (figures 4a, 4b et 4b'). De la résine isolante 6 est alors déposée dans les rainures 20 (figure 4c).

Selon une variante, les rainures sont découpées dans la plaque nue et la résine 6 est déposée à la fois dans les rainures et sur la plaque de manière à former sur celle-ci la couche mince 4.

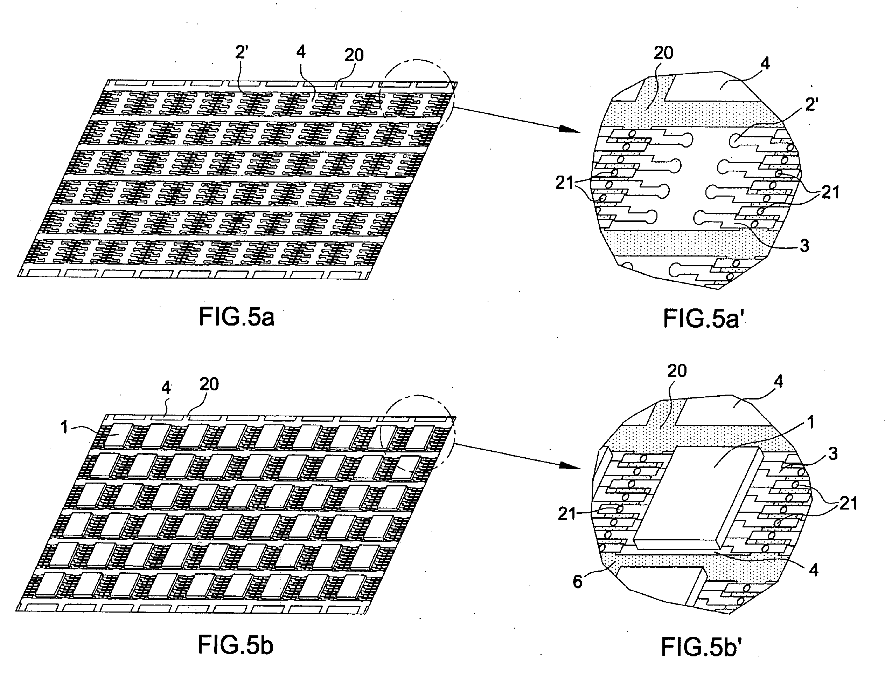

Les zones 2' de connexion électrique, c'est-à-dire les plots de connexion aux composants et les éléments d'interconnexion des composants tels que des pistes 3 (figure 5a) sont réalisés sur cette face de la plaque par gravure par exemple, selon une méthode classique connue de l'homme du métier. L'élément d'interconnexion 3 s'étend au moins jusqu'à la rainure 20, voire même forme un pont qui l'enjambe comme on le voit figures 5a' et 5b'. Si nécessaire, il est évidé à l'intersection avec la rainure 20 pour former une zone d'ouverture 21 (figures 5a' et 5b') destinée au percement d'un trou lorsque les plaques seront empilées et pour isoler électriquement les composants entre eux en vue d'un test collectif ultérieur. Lorsque ce test n'est pas prévu, la zone d'ouverture 21 peut être formée en ménageant une continuité de l'élément d'interconnexion au niveau de la rainure, par exemple lorsque cet élément relie deux plots de connexion situés de part et d'autre de la rainure 20.

Les composants 1 sont reportés sur cette face de la plaque au niveau des motifs 25, face active vers la plaque selon une méthode dite « Flip Chip » de manière à connecter chaque composant avec ses plots de connexion (figures 5b et 5b').

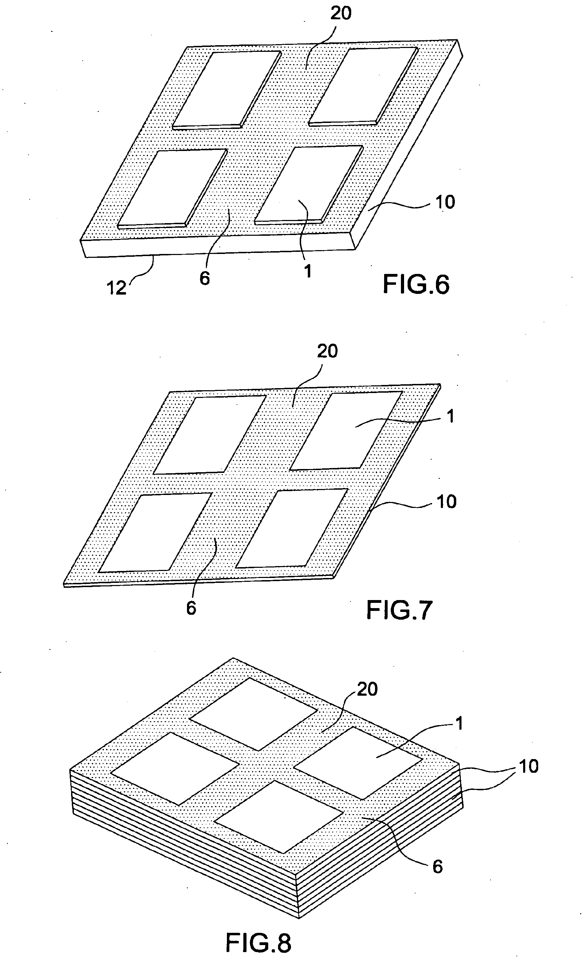

Les composants 1 sont alors enrobés d'une résine isolante 6 de manière classique (figure 6).

Jusqu'à cette étape, la plaque de silicium 10 assure un support continu de fabrication du lot de n tranches i. Cette continuité disparaît lors de l'étape suivante.

En effet, la plaque est alors amincie par surfaçage de l'autre face 12 de manière à faire apparaître la résine 6 des rainures (figure 7).

La fabrication de ce lot 50 de n tranches est répétée K fois en vue d'obtenir les K plaques.

Les K plaques sont empilées les unes sur les autres par collage par exemple, en faisant coïncider les zones d'ouverture (figure 8).

Une couche isolante 4 est déposée sur une face de l'empilement parallèle aux plaques 10, sur laquelle sont situés des éléments d'interconnexion électrique 2' et 3 de l'empilement. Une zone d'ouverture 21 centrée sur les zones d'ouverture des tranches est également prévue. Les éléments d'interconnexion qui sont destinés à être reliés aux tranches s'étendent donc jusqu'à cette zone. Cette couche peut être réalisée sur l'empilement ou avant l'empilement puis ajoutée à celui-ci.

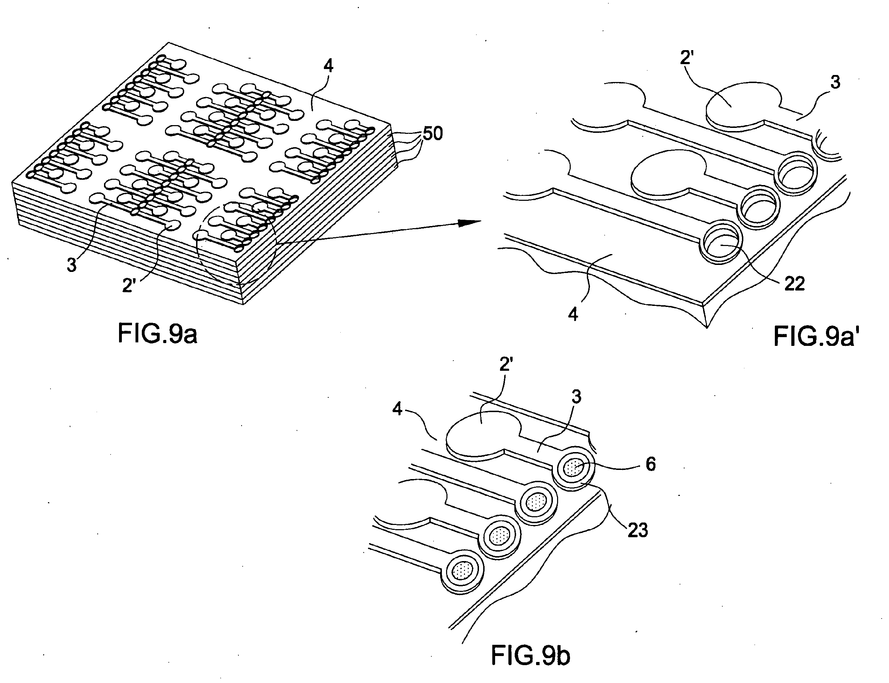

Les trous 22 ou vias sont percés à travers l'empilement à l'aplomb de la zone d'ouverture de cette dernière couche (figure 9a') ; ce percement 22 est obtenu à travers un masque par exemple en utilisant une gravure sèche par plasma (ou « RIE acronyme de l'expression anglo-saxonne Reactive Ion Etching) ou par ablation par laser de type excimère. On arrête la gravure lorsque le trou est percé. A l'issue de cette gravure, les trous obtenus ont une dimension transverse (c'est-à-dire dans le sens de la largeur de la rainure) inférieure à L1 de manière à ce que le silicium des plaques soit isolé de la paroi du trou 22 par de la résine 6, et les ponts affleurent sur la paroi des trous.

La paroi des trous est alors métallisée avec une couche métallique 23 (figure 9b), ce qui permet d'établir une connexion entre les ponts qui affleurent et le trou et donc d'établir une connexion entre les tranches.

Les trous 22 sont éventuellement remplis de résine 6 en vue de faciliter le découpage généralement réalisé par sciage (figures 9b et 10 et 10').

L'empilement est découpé selon les rainures, en vue d'obtenir les n modules électroniques 100 (figure 10).

Selon un autre mode de réalisation, une couche mince d'un matériau isolant est déposée sur une face de la plaque et forme le substrat. Des plots de connexion électrique des composants et des éléments d'interconnexion électrique auxquels ils sont reliés, sont disposés sur ladite face. Les éléments d'interconnexion des composants sont disposés de manière à ménager un emplacement pour les rainures qui sont ensuite formées selon-par exemple un même motif rectangulaire.

Les composants sont reportés sur cette face de la plaque dans chaque motif, face active vers la plaque selon une méthode dite « Flip Chip » de manière à connecter chaque composant avec ses plots de connexion. Les éléments de connexion sont reliés à des fils destinés à affleurer sur les parois des futurs trous. A cet effet, ils enjambent au moins partiellement les rainures. Eventuellement, ces fils relient des éléments de connexion situés de part et d'autre d'une rainure. Compte tenu de la minceur de ces fils de l'ordre de 25µm de diamètre, il existe de fait une zone d'ouverture située à l'intersection des fils et de la rainure, plus large bien sûr que les fils et destinée au percement d'un trou lorsque les plaques seront empilées.

Les composants sont enrobés d'une résine isolante qui remplit aussi les rainures. Comme pour le mode de réalisation précédent, ces rainures permettent d'isoler électriquement chaque module.

Eventuellement, lorsque les fils relient des éléments de connexion situés de part et d'autre d'une rainure, ils sont coupés le long des rainures sur une largeur L2 inférieure à L1 : la résine située à cet endroit est donc aussi coupée.

Jusqu'à cette étape, la plaque de silicium assure un support continu de fabrication du lot de n tranches i. Cette continuité disparaît lors de l'étape suivante.

La plaque est alors amincie par surfaçage de l'autre face de manière à faire apparaître la résine des rainures. Le surfaçage est réalisé par abrasion mécanique ou chimique.

La fabrication de ce lot de n tranches est répétée K fois en vue d'obtenir les K plaques.

Les K plaques sont empilées les unes sur les autres par collage par exemple, en faisant coïncider les zones d'ouverture.

Une couche isolante est déposée sur une face de l'empilement parallèle aux plaques, sur laquelle sont disposés des éléments d'interconnexion électrique de l'empilement. Une zone d'ouverture centrée sur les zones d'ouverture des tranches est également prévue. Les éléments d'interconnexion qui sont destinés à être reliés aux tranches s'étendent donc également jusqu'à cette zone. Cette couche peut être réalisée avant l'empilement puis ajouté à celui-ci.

Les trous ou vias sont percés à travers l'empilement à l'aplomb de la zone d'ouverture. Ce percement est obtenu à travers un masque par exemple en utilisant une gravure liquide par photolithographie de manière à ce que la résine située à l'aplomb des fils soit également éliminée lorsque les câbles enjambent la rainure ; sinon, une gravure sèche telle que décrite précédemment peut être utilisée. On arrête la gravure lorsque le trou est percé. A l'issue de cette gravure, les trous obtenus ont une dimension transverse (c'est-à-dire dans le sens de la largeur de la rainure) inférieure à L1 de manière à ce que le silicium des tranches soit isolé de la paroi du trou par de la résine, et les fils affleurent sur la paroi des trous.

La paroi des trous est alors métallisée, ce qui permet d'établir une connexion entre les fils qui affleurent et le trou et donc d'établir une connexion entre les tranches.

Les trous sont éventuellement remplis de résine en vue de faciliter le découpage.

L'empilement est découpé selon les rainures, en vue d'obtenir les n modules électroniques.

## Revendications

1. Procédé de fabrication de n modules électroniques, n étant un entier supérieur à 1, un module comportant un empilement de K tranches électroniques, une tranche i, i variant de 1 à K comprenant sur un substrat isolant au moins un composant électronique, les K tranches étant reliées électriquement entre elles par des conducteurs situés sur les faces latérales de l'empilement, **caractérisé en ce que** la fabrication est collective et comprend :
une première étape consistant pour chaque tranche i, en :
A1) une étape de fabrication d'un lot de n tranches i sur une même plaque mince plane d'épaisseur eₚ comprenant du silicium, recouverte sur une face d'une couche mince électriquement isolante d'épaisseur eᵢ, formant le substrat, avec sur cette face des rainures de largeur L1 et de profondeur supérieure à eᵢ et inférieure eₚ+eᵢ, ces rainures délimitant au moins n motifs géométriques, chaque motif étant muni d'au moins un composant électronique en silicium connecté à des plots de connexion électrique disposés sur ladite face, les plots étant reliés à des éléments de connexion électrique s'étendant au moins jusqu'à une rainure, une zone d'ouverture d'un trou étant prévue à l'intersection des rainures et des éléments de connexion, la dimension transverse de cette zone étant inférieure à L1, les composants étant enrobés d'une résine isolante qui remplit aussi les rainures,
B1) une étape d'amincissement par surfaçage de l'autre face de la plaque de manière à faire apparaître la résine des rainures,
une deuxième étape consistant à :
A2) empiler et assembler les K lots obtenus à l'issue de la première étape, de manière à superposer les zones d'ouverture, sensiblement les unes sur les autres,
B2) percer des trous dans la résine perpendiculairement aux faces des plaques sur toute l'épaisseur de l'empilement à l'aplomb des zones d'ouverture, la dimension transverse des trous étant inférieure à L1, de manière à ce que le silicium soit isolé de la paroi du trou par de la résine,
C2) métalliser la paroi des trous,
D2) découper l'empilement selon les rainures en vue d'obtenir les n modules électroniques.

2. Procédé selon la revendication précédente, **caractérisé en ce qu'**il comprend en outre préalablement à la deuxième l'étape, une étape d'amincissement de la plaque par surfaçage de la face de la plaque comportant les composants.

3. Procédé selon l'une quelconque des revendications précédentes, **caractérisé en ce que** préalablement à l'étape D2, il comprend une étape consistant à déposer une couche électriquement isolante sur une face de l'empilement parallèle aux plaques, cette couche comprenant au niveau de chaque motif, des éléments d'interconnexion électrique du module qui ménagent des zones d'ouverture centrées sur les zones d'ouverture des tranches, et qui s'étendent jusqu'à ces zones.

4. Procédé selon l'une quelconque des revendications précédentes, **caractérisé en ce que** la deuxième étape comprend en outre une étape suivant l'étape de métallisation des parois des trous, consistant à reboucher les trous avec de la résine en vue de faciliter la découpe ultérieure de l'empilement.

5. Procédé selon l'une quelconque des revendications précédentes, **caractérisé en ce que** le composant électronique est un composant actif ou passif ou un MEMS.

6. Procédé selon la revendication précédente, **caractérisé en ce que** le composant actif est une puce nue.

7. Procédé selon l'une quelconque des revendications précédentes, **caractérisé en ce qu'**au moins un composant passif est situé dans la plaque ou sur la plaque.

8. Procédé selon l'une quelconque des revendications précédentes, **caractérisé en ce que** la couche mince isolante est en résine isolante.

9. Procédé selon l'une quelconque des revendications précédentes, **caractérisé en ce que** les éléments de connexion électriques enjambent les ramures.

10. Procédé selon la revendication précédente, **caractérisé en ce que** des éléments de connexion électrique relient deux plots situés de part et d'autre d'une rainure.

11. Procédé selon l'une quelconque des revendications précédentes, **caractérisé en ce qu'**il comprend en outre préalablement au découpage de l'étape D2, une étape consistant à tester électriquement l'empilement obtenu.

12. Procédé selon l'une quelconque des revendications précédentes, **caractérisé en ce que** les éléments de connexion électriques sont des ponts gravés.

13. Procédé selon la revendication précédente, **caractérisé en ce que** les ponts sont gravés après avoir rempli les rainures de résine et avant d'enrober les composants de résine.

14. Procédé selon la revendication précédente, **caractérisé en ce que** les trous sont percés par gravure sèche.

15. Procédé selon l'une quelconque des revendications 1 à 11, **caractérisé en ce que** les éléments de connexion électriques sont des fils câblés.

16. Procédé selon la revendication précédente, **caractérisé en ce que** les fils sont sectionnés le long des rainures.

17. Procédé selon l'une quelconque des revendications 15 ou 16, **caractérisé en ce que** les trous sont percés par gravure liquide.

## Claims

1. Method of fabricating n electronic modules, n being an integer greater than 1, a module comprising a stack of K electronic wafers, a wafer i, i varying from 1 to K comprising on an insulating substrate at least one electronic component, the K wafers being electrically interlinked by conductors located on the lateral sides of the stack, **characterized in that** the fabrication is collective and comprises:
a first step consisting, for each wafer i, in:
A1) a step for fabricating a batch of n wafers i on one and the same flat thin sheet of thickness eₚ consisting of silicon, covered on one face with a thin electrically insulating layer of thickness eᵢ, forming the substrate, with, on this face, grooves of width L1 and of depth greater than eᵢ and less than eₚ+eᵢ, these grooves delimiting at least n geometrical patterns, each pattern being provided with at least one silicon electronic component connected to electrical connection terminals disposed on said face, the terminals being linked to electrical connection elements extending at least as far as a groove, a hole-opening area being provided at the intersection of the grooves and of the connection elements, the transverse dimension of this area being less than L1, the components being coated with an insulating resin which also fills the grooves,
B1) a thinning step by surface grinding of the other face of the sheet so as to reveal the resin of the grooves,
a second step consisting in:
A2) stacking and assembling the K batches obtained on completion of the first step, so as to superimpose the opening areas, substantially one on top of the other,
B2) drilling holes in the resin perpendicularly to the faces of the sheets through the entire thickness of the stack plumb with the opening areas, the transverse dimension of the holes being less than L1 so that the silicon is insulated from the wall of the hole by the resin,
C2) metallizing the wall of the holes,
D2) cutting the stack along the grooves in order to obtain the n electronic modules.

2. Method according to the preceding claim, **characterized in that** it also comprises, prior to the second step, a step for thinning the sheet by surface grinding of the face of the sheet comprising the components.

3. Method according to either of the preceding claims, **characterized in that**, prior to the step D2, it comprises a step consisting in depositing an electrically insulating layer on one face of the stack parallel to the sheets, this layer comprising, at the level of each pattern, elements for electrically interconnecting the module which provide opening areas centered on the opening areas of the wafers, and which extend as far as these areas.

4. Method according to any one of the preceding claims, **characterized in that** the second step also comprises a step following the step for metallizing the walls of the holes, consisting in refilling the holes with resin in order to facilitate the subsequent cutting of the stack.

5. Method according to any one of the preceding claims, **characterized in that** the electronic component is an active or passive component or an MEMS.

6. Method according to the preceding claim, **characterized in that** the active component is a bare chip.

7. Method according to any one of the preceding claims, **characterized in that** at least one passive component is located in or on the sheet.

8. Method according to any one of the preceding claims, **characterized in that** the insulating thin layer is made of insulating resin.

9. Method according to any one of the preceding claims, **characterized in that** the electrical connection elements straddle the grooves.

10. Method according to the preceding claim, **characterized in that** the electrical connection elements link two terminals located either side of a groove.

11. Method according to any one of the preceding claims, **characterized in that** it also comprises, prior to the cutting of the step D2, a step consisting in electrically testing the resulting stack.

12. Method according to any one of the preceding claims, **characterized in that** the electrical connection elements are etched bridges.

13. Method according to the preceding claim, **characterized in that** the bridges are etched after having filled the grooves with resin and before coating the components with resin.

14. Method according to the preceding claim, **characterized in that** the holes are drilled by dry etching.

15. Method according to any one of Claims 1 to 11, **characterized in that** the electrical connection elements are wired filaments.

16. Method according to the preceding claim, **characterized in that** the filaments are cropped along the grooves.

17. Method according to either of Claims 15 and 16, **characterized in that** the holes are drilled by liquid etching.

## Patentansprüche

1. Verfahren zur Herstellung von n elektronischen Modulen, mit n einer ganzen Zahl größer als 1, wobei ein Modul einen Stapel von K elektronischen Wafern aufweist, wobei ein Wafer i, mit i von 1 bis K variierend, auf einem isolierenden Substrat mindestens ein elektronisches Bauteil enthält, wobei die K Wafer elektrisch miteinander durch Leiter verbunden sind, die sich auf den Seitenflächen des Stapels befinden, **dadurch gekennzeichnet, dass** die Herstellung kollektiv ist und enthält:
einen ersten Schritt, der für jeden Wafer i besteht aus:
A1) einem Schritt der Herstellung einer Partie von n Wafern i auf der gleichen ebenen, dünnen, Silicium enthaltenden Platte einer Dicke eₚ, die auf einer Seite mit einer dünnen elektrisch isolierenden Schicht einer Dicke eᵢ bedeckt ist, welche das Substrat bildet, mit auf dieser Seite Rillen einer Breite L1 und einer Tiefe größer als eᵢ und kleiner als eₚ+eᵢ, wobei diese Rillen mindestens n geometrische Muster begrenzen, wobei jedes Muster mit mindestens einem elektronischen Bauteil aus Silicium versehen ist, das mit auf der Seite angeordneten elektrischen Anschlusskontakten verbunden ist, wobei die Kontakte mit elektrischen Verbindungselementen verbunden sind, die sich mindestens bis zu einer Rille erstrecken, wobei eine Öffnungszone eines Lochs an der Schnittstelle der Rillen und der Verbindungselemente vorgesehen ist, wobei die Querabmessung dieser Zone kleiner als L1 ist, wobei die Bauteile mit einem Isolierharz umhüllt sind, das auch die Rillen füllt,
B1) einem Schritt der Verdünnung durch Flächenbearbeitung der anderen Seite der Platte, um das Harz der Rillen hervortreten zu lassen,
einen zweiten Schritt, der darin besteht:
A2) die am Ende des ersten Schritts erhaltenen K Partien derart zu stapeln und zusammenzufügen, dass die Öffnungszonen im Wesentlichen übereinander angeordnet werden,
B2) lotrecht zu den Seiten der Platten über die ganze Dicke des Stapels senkrecht zu den Öffnungszonen Löcher in das Harz zu bohren, wobei die Querabmessung der Löcher kleiner als L1 ist, damit das Silicium durch Harz von der Wand des Lochs isoliert wird,
C2) die Wand der Löcher zu metallisieren,
D2) den Stapel gemäß den Rillen zu zerschneiden, um die n elektronischen Module zu erhalten.

2. Verfahren nach dem vorhergehenden Anspruch, **dadurch gekennzeichnet, dass** es außerdem vor dem zweiten Schritt einen Schritt der Verdünnung der Platte durch Flächenbearbeitung der die Bauteile aufweisenden Seite der Platte enthält.

3. Verfahren nach einem der vorhergehenden Ansprüche, **dadurch gekennzeichnet, dass** es vor dem Schritt D2 einen Schritt enthält, der darin besteht, eine elektrisch isolierende Schicht auf eine Seite des Stapels parallel zu den Platten aufzubringen, wobei diese Schicht in Höhe jedes Musters elektrische Verbindungselemente des Moduls enthält, die auf die Öffnungszonen der Wafer zentrierte Öffnungszonen freilassen, und die sich bis zu diesen Zonen erstrecken.

4. Verfahren nach einem der vorhergehenden Ansprüche, **dadurch gekennzeichnet, dass** der zweite Schritt außerdem einen Schritt nach dem Schritt der Metallisierung der Wände der Löcher enthält, der darin besteht, die Löcher wieder mit Harz zu verstopfen, um das spätere Schneiden des Stapels zu erleichtern.

5. Verfahren nach einem der vorhergehenden Ansprüche, **dadurch gekennzeichnet, dass** das elektronische Bauteil ein aktives oder passives Bauteil oder ein MEMS ist.

6. Verfahren nach dem vorhergehenden Anspruch, **dadurch gekennzeichnet, dass** das aktive Bauteil ein nackter Chip ist.

7. Verfahren nach einem der vorhergehenden Ansprüche, **dadurch gekennzeichnet, dass** mindestens ein passives Bauteil sich in der Platte oder auf der Platte befindet.

8. Verfahren nach einem der vorhergehenden Ansprüche, **dadurch gekennzeichnet, dass** die dünne isolierende Schicht aus isolierendem Harz ist.

9. Verfahren nach einem der vorhergehenden Ansprüche, **dadurch gekennzeichnet, dass** die elektrischen Verbindungselemente die Rillen überspannen.

10. Verfahren nach dem vorhergehenden Anspruch, **dadurch gekennzeichnet, dass** elektrische Verbindungselemente zwei Kontakte verbinden, die sich zu beiden Seiten einer Rille befinden.

11. Verfahren nach einem der vorhergehenden Ansprüche, **dadurch gekennzeichnet, dass** es außerdem vor dem Schneiden des Schritts D2 einen Schritt aufweist, der darin besteht, den erhaltenen Stapel elektrisch zu testen.

12. Verfahren nach einem der vorhergehenden Ansprüche, **dadurch gekennzeichnet, dass** die elektrischen Verbindungselemente eingeätzte Brücken sind.

13. Verfahren nach dem vorhergehenden Anspruch, **dadurch gekennzeichnet, dass** die Brücken eingeätzt werden, nachdem die Rillen mit Harz gefüllt wurden und bevor die Bauteile mit Harz umhüllt werden.

14. Verfahren nach dem vorhergehenden Anspruch, **dadurch gekennzeichnet, dass** die Löcher durch Trockenätzen gebohrt werden.

15. Verfahren nach einem der Ansprüche 1 bis 11, **dadurch gekennzeichnet, dass** die elektrischen Verbindungselemente Kabeldrähte sind.

16. Verfahren nach dem vorhergehenden Anspruch, **dadurch gekennzeichnet, dass** die Kabeldrähte entlang der Rillen zertrennt werden.

17. Verfahren nach einem der Ansprüche 15 oder 16, **dadurch gekennzeichnet, dass** die Löcher durch Flüssigätzen gebohrt werden.
